# EUROPÄISCHE PATENTSCHRIFT

(11) **EP 0 838 986 B1**
(45) Veröffentlichungstag und Bekanntmachung des Hinweises auf die Patenterteilung: **01.12.1999**
(21) Anmeldenummer: 97117626.8
(22) Anmeldetag: 11.10.1997
(51) Int. Cl.: H05K 7/14, H05K 9/00

(54) **Baugruppenträger**
Electronic rack
Baie électronique

(30) Priorität: 25.10.1996 DE 19644418
(43) Veröffentlichungstag der Anmeldung: 29.04.1998
(73) Patentinhaber: Schroff GmbH, D-75334 Straubenhardt (DE)
(72) Erfinder: Günther, Hans-Ulrich, 76327 Pfinztal (DE); Mazura, Paul, 76302 Karlsbad (DE); Haag, Volker, 75323 Bad Wildbad (DE); Pfeifer, Klaus, 76199 Karlsruhe (DE); Thalau, Klaus-Michael, 76316 Malsch (DE); Joist, Michael, 76571 Gaggenau (DE); Weiss, Udo, 75334 Straubenhardt (DE)
(74) Vertreter: Durm, Klaus, Dr.-Ing.

(56) Entgegenhaltungen:
- EP-A- 0 596 349
- DE-C- 4 223 322
- US-A- 5 506 751

## Beschreibung

Die Erfindung betrifft einen Baugruppenträger zur Aufnahme von mit elektrischen und elektronischen Bauteilen bestückten Steckbaugruppen, mit zwei parallelen Seitenwänden, die durch wenigstens vier Modulschienen miteinander verbunden sind, mit je einem Deckblech an seiner Oberseite und an seiner Unterseite, mit Lochreihen für Befestigungsschrauben an den oberen und den unteren Rändern der Seitenwände und mit wenigstens einem Befestigungselement, welches an der Lochreihe angebracht und an dem das Deckblech befestigt ist; (vgl. z.B. EP-A-0 453 668).

Anwendung findet die Erfindung bei Baugruppenträgern jeglicher Art und Abmessungen, die zum Einsetzen in Geräteschränke, Gehäuse oder Gestelle für die Industrieelektronik vorgesehen sind.

Baugruppenträger, wie sie nach Art eines Rahmengestelles aus zwei Seitenwänden mit wenigstens vier diese verbindenden Profilschienen zusammengesetzt sind, werden häufig zum Schutz ihrer Einbauten mit oberen und unteren Deckblechen versehen. Diese Deckbleche schützen die Einbauten in erster Linie gegen mechanische Beschädigungen beim Transport oder während des Betriebes, sie können aber auch zugleich als Schirmung dienen. In dieser Funktion verhindern sie die Ein- und Ausstrahlung hochfrequenter Störungen. Die Deckbleche müssen demzufolge nicht nur eine ausreichende mechanische Stabilität besitzen und einwandfrei mit den Seitenwänden verbunden sein, sondern auch elektrisch leitfähig mit den beiden Seitenwänden in Verbindung stehen.

Die elektrische Verbindung von Deckblechen und Modulschienen bei Baugruppenträgern ist beispielsweise in der DE 42 23 322 der Anmelderin beschrieben, sie geschieht durch in mit Federelementen versehenen Längsrinnen der Modulschienen eingreifende Randleisten der Deckbleche.

Die Befestigung der Deckbleche an den Seitenwänden geschieht allerdings bisher einfach durch Schraubverbindungen, wozu die Deckbleche seitlich abgekantet sind und mit Gewinden zur Aufnahme von Befestigungsschrauben versehen werden. Dabei besteht bei der Montage oder unter Wärmeeinwirkung die Gefahr des Verziehens des Deckbleches oder der Verspannung bzw. Verbiegung der Seitenwand. Weiterhin nachteilig ist bei dieser Befestigungsart, daß eine Vielzahl von Deckblechvarianten vorhanden sein muß, mit welchen den unterschiedlichen Montagemöglichkeiten der Modulschienen Rechnung getragen wird. Ein nachträgliches Versetzen der Modulschienen in andere Positionen ist nur nach Entfernen eines Abschnittes der Randleisten möglich. Wegen der Abstände zwischen den Befestigungspunkten der in Reihe nebeneinander sitzenden Befestigungsschrauben ist eine gute hochfrequenzmäßige Abschirmung nur bei Verwendung einer größeren Zahl von Schrauben möglich.

Es ist auch bekannt, die Abdeckbleche mittels Abstützelementen an den Seitenwänden zu befestigen. Hierbei werden plattenförmige Stützelemente zunächst mit Halteschrauben an den Rändern der Seitenwände befestigt und sodann die am Rand gelochten Abdeckungen unter Verwendung von Haltefedern und Einsatz von Befestigungsschrauben mit den Abstützelementen verbunden. Diese Befestigungsart ist aufwendig hinsichtlich Material und Montage; eine HF-mäßige Abdichtung der Längsschlitze zwischen den Seitenwänden und den Abdeckungen ist nicht vorgesehen (EP-A-0 453 668).

Darüber hinaus ist ein Baugruppenträger bekannt, bei dem leitende Kontaktfedern mit S-förmigem Querschnitt eine niederohmige Verbindung zwischen den metallischen, durch Modulschienen miteinander verbundenen Seitenwänden aus Aluminium und dem oberen bzw. unteren Abdeckblech herstellen. Die seitlichen Enden der Abdeckbleche sind rechtwinkelig abgekantet und werden von der einen, rinnenförmigen Hälfte der Kontaktfedern umfaßt, während die anderen, entgegengesetzt geöffneten Hälften sich unter Federspannung um die Ränder der Seitenwände legen. Zwar wird durch die aufgesteckten Kontaktfedern eine zuverlässige HF-mäßige Abdichtung der Spalte zwischen den Abdeckblechen und den Seitenwänden erzielt, jedoch fehlt eine mechanische Verbindung zwischen den Blechen und den Wänden (DE 42 37 447 = EP-A-0 596 349).

Kontaktleisten bzw. Kontaktfedern für störstrahlungssichere Verbindungen aneinanderstoßender metallischer Wandelemente sind an sich in verschiedenen Ausführungsformen bekannt (DE 94 01 533 U1 und DE 90 03 209 U1).

Es ist die Aufgabe der Erfindung, ein Befestigungselement für die Deckbleche an den Seitenwänden von Baugruppenträgern so auszugestalten, daß bei nur geringem technischen Aufwand und schneller Montagemöglichkeit eine preisgünstige, innen anliegende Verbindung herstellbar ist, die eine für die hier in Betracht kommenden Frequenzbereiche ausreichend gute hochfrequenzmäßige Abdichtung der Spalte zwischen den Bauteilen gewährleistet, Fertigungstoleranzen auszugleichen in der Lage ist und die Teile mechanisch verbindet.

Ausgehend von einem Baugruppenträger der eingangs beschriebenen Bauart wird die gestellte Aufgabe dadurch gelöst, daß das Befestigungselement ein Winkelträger aus dünnem, federelastischen Stahlblech ist und zwei Winkelschenkel aufweist, die einen Winkel einschließen, der mehr als neunzig Winkelgrade beträgt, daß der erste Winkelschenkel des Winkelträgers zwischen Seitenwand und Deckblech eingesetzt ist, daß der erste Winkelschenkel eine Schraubenaufnahme für eine Befestigungsschraube trägt, daß die Verbindungsschraube durch ein Loch der Lochreihe hindurchgeführt und in die Schraubenaufnahme eingedreht ist, daß der zweite Winkelschenkel wenigstens eine durch Ausstanzung dieses Winkelschenkels hergestellte Auflage für das Deckblech aufweist, daß dieser zweite Winkelschenkel zusammen mit der Auflage eine U-förmige, federnde Klammer bildet, und daß die Klammer zur Aufnahme des Randes des an die Seitenwand anstoßenden Deckbleches dient.

Bei der Montage werden mehrere der vorgeschlagenen Befestigungselemente an beiden Seiten des Deckbleches an denjenigen Stellen auf den Rand aufgeschoben, an welchen keine Modulschienen Platz beanspruchen. Sodann wird das Deckblech zwischen die Seitenwände eingefügt und die Befestigungselemente angeschraubt. Dies kann mit wenigen Handgriffen geschehen.

Aus Gründen einfacher Fertigung kann als Schraubenaufnahme ein aus einer Stanzung und Prägung hergestelltes Loch dienen.

Vorteilhaft weist der erste Winkelschenkel eine Abkantung auf, die zum zweiten Winkelschenkel hin gerichtet ist. Diese Maßnahme erleichtert das Einsetzen der mit den Befestigungselementen bestückten Deckbleche, weil dabei die Schräge der Abkantung die ersten Winkelschenkel an den Innenkanten der Seitenwände vorbeiführt.

Eine weitere Ausgestaltung der Erfindung ist gekennzeichnet durch an die Stirnseiten des Winkelträgers angeformte Winkelteile mit zwei Schenkeln, deren einer eine Konsole für das Deckblech aufweist und der andere Schenkel mit der Konsole eine federnde, U-förmige Aufnahme für das Deckblech bildet. Dieses Winkelteil dient der Verlängerung der Befestigungselemente, ohne daß ein zusätzliches Anschrauben an der Seitenwand erforderlich ist, es wird dabei die HF-Abdichtung des Spaltes zwischen Deckblech und Seitenwand erweitert.

Zweckmäßig weist ein Schenkel des Winkelteiles an seiner Außenseite eine Kontaktkuppe auf, die zur Verbesserung der Kontaktgabe an der Seitenwand vorgesehen ist.

Vorteilhaft weist der eine Schenkel des Winkel teiles eine zum zweiten Schenkel hin gerichtete Abbiegung auf. Diese Abbiegung dient zur Erleichterung des Einsetzens der Deckbleche genauso wie die Abkantung des ersten Winkelschenkels des Befestigungselementes.

Zwischen dem Winkelträger und dem Winkelteil kann eine Sollbruchstelle zum leichten Abbrechen des Winkel teiles vorgesehen sein für den Fall, daß dieser Teil nicht benötigt wird.

Zur rationellen Herstellung und problemlosen Anpassung an die verschiedenen Gegebenheiten bei unterschiedlichen Baugruppenträgern ist es von Vorteil, wenn mehrere Winkelträger mit mehreren Winkelteilen zusammenhängen und ein Band bilden.

Die Erfindung wird nachstehend anhand der beigefügten drei Zeichnungsblätter näher erläutert. Dabei zeigen
- Figur 1: einen Vertikalschnitt durch einen Baugruppenträger, von der Rückseite her gesehen, in verkleinertem Maßstab;
- Figur 2: die rechte obere, eingekreiste Ecke des Baugruppenträgers nach Figur 1, die beteiligten Bauteile in außeneinandergezogener Lage;
- Figur 3: einen Winkelträger in einem Querschnitt, in stark vergrößerter Darstellung;
- Figur 4: den Anfang eines Bandes mit einem Winkelträger und zwei angesetzten Winkelteilen, in einer Seitenansicht;
- Figur 5: das Band gemäß Figur 4, in einer Draufsicht;
- Figur 6: das Band nach den Figuren 4 und 5, in einer perspektivischen Wiedergabe von der Seite her betrachtet;
- Figur 7: das Band nach Figuren 4 und 5, ebenfalls perspektivisch, von der anderen Seite gesehen.

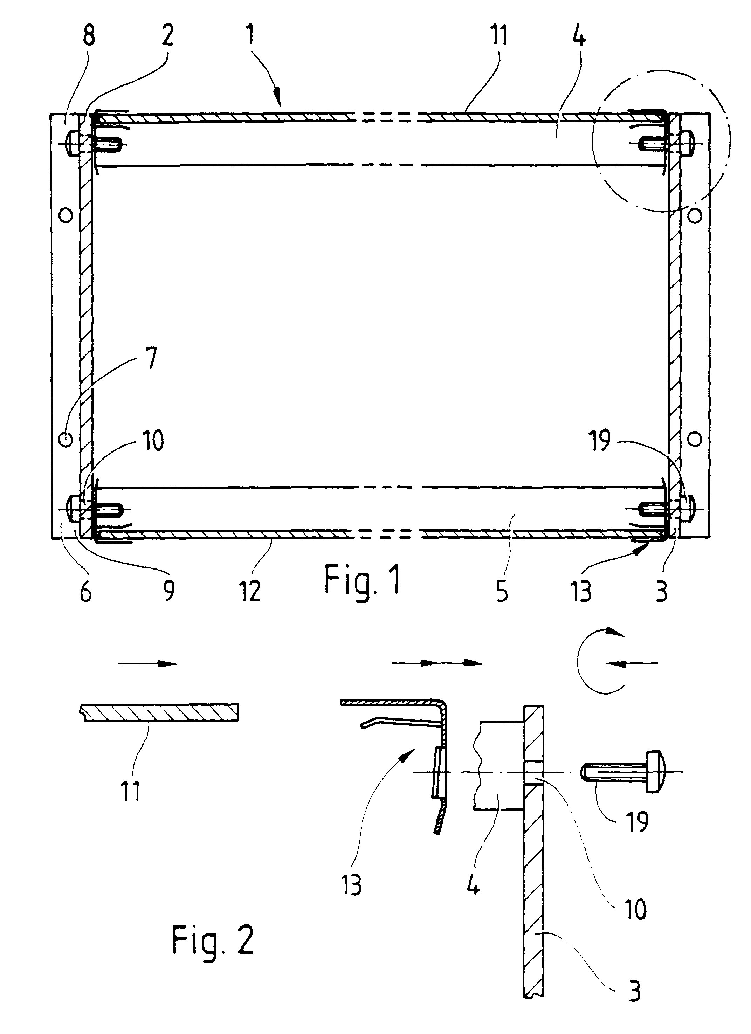

Der in Figur 1 in einem Vertikalschnitt vereinfacht wiedergegebene Baugruppenträger 1 dient zur Aufnahme von (nicht dargestellten) Steckbaugruppen, die zur Bestückung mit elektrischen und elektronischen Bauteilen jeweils eine Leiterkarte aufweisen, an der eine Frontplatte sitzt.

Der Baugruppenträger 1 weist zwei parallelstehende Seitenwände 2 und 3 aus Aluminiumblech sowie vier profilierte Profilschienen aus Aluminium auf, von denen die vordere obere und die vordere untere Modulschiene 4 und 5 erkennbar sind. Die Seitenwände 2 und 3 sind mit Befestigungsflanschen 6 ausgestattet, die Schraublöcher aufweisen, mit deren Hilfe der Baugruppenträger 1 in einen Geräteschrank oder an einem Rahmengestell befestigt werden kann.

Die Seitenwände 2 und 3 sind unter Verwendung von (nicht dargestellten) Schrauben an den Modulschienen 4 und 5 angeschraubt, zu diesem Zweck sind in den oberen und unteren Rändern 8 und 9 der Seitenwände 2 und 3 Lochreihen 10 vorgesehen.

Zum Verschließen des Baugruppenträgers 1 dienen zwei Deckbleche 11 und 12, die an der Oberseite und der Unterseite lösbar befestigt sind.

Zur Befestigung der beiden Deckbleche 11 und 12 dienen Befestigungselemente, die an den Lochreihen 10 angebracht sind und an denen das betreffende Deckblech 11 bzw. 12 mit seinem Rand gehalten ist.

Die Befestigungselemente verbinden die Deckbleche 11 und 12 sowohl mechanisch wie elektrisch mit den Seitenwänden 2 und 3. Bei diesen Befestigungselementen handelt es sich um Winkel träger 13 aus einem dünnen, federelastischen Stahlblech, vorzugsweise aus Chrom-Nickel-Stahl, die durch eine Anzahl nacheinander folgender Stanz- und Prägeschritte hergestellt sind.

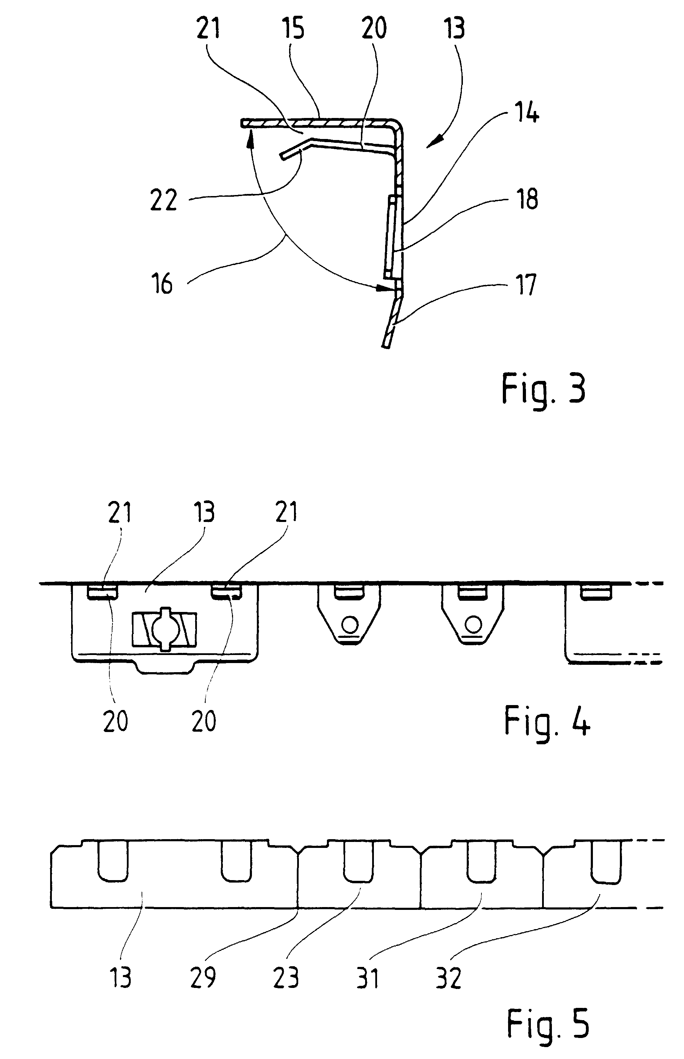

Jeder Winkelträger 13 besitzt - vergleiche Figur 3 - einen ersten Winkelschenkel 14 und einen zweiten Winkelschenkel 15. Diese beiden Winkelschenkel 14, 15 schließen einen Winkel 16 ein, der neunzig Winkelgrade (oder etwas mehr) beträgt. Dabei weist der erste Winkelschenkel 14 eine Abkantung 17 auf, die zum zweiten Winkelschenkel 15 hin gerichtet ist und einen stumpfen Winkel von etwa einhundertfünfundsiebzig Winkelgrade mit dem ersten Winkelschenkel 14 einschließt.

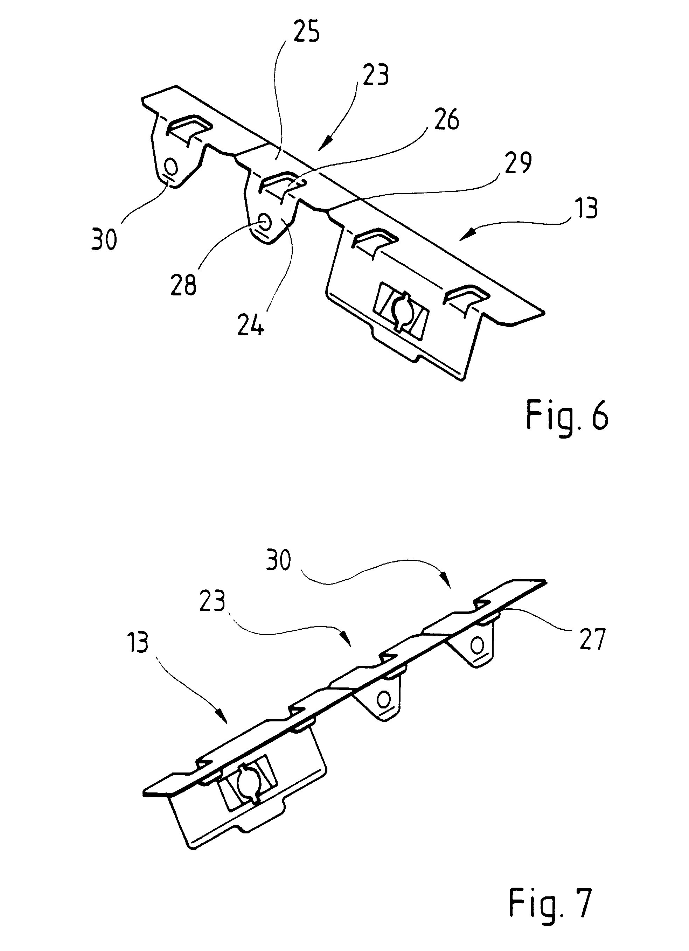

Der erste Winkelschenkel 14 ist bei montiertem Deckblech 11, 12 zwischen dem betreffenden Deckblech 11 bzw. 12 und der anliegenden Seitenwand 2 bzw. 3 eingesetzt. Er trägt eine Schraubenaufnahme 18 für eine Befestigungsschraube 19. Diese Befestigungsschraube ist von außen her durch ein Loch an der Lochreihe 10 hindurchgeführt und mit ihrem Gewinde in die Schraubenaufnahme 18 hineingedreht. Bei der Schraubenaufnahme 18 handelt es sich um ein mit zwei Randausnehmungen versehenes, gestanztes Loch, dessen Rändern durch Prägung die Form von zwei halben Gewindegängen erteilt ist - vergleiche Figuren 4, 6 und 7. Die Schraubenaufnahme 18 kann auch eine flache Schraubenmutter sein.

Der zweite Winkelschenkel 15 weist zwei Auflagen 20 für das betreffende Deckblech 11 bzw. 12 auf, die durch Ausstanzungen des zweiten Winkelschenkels 15 hergestellt sind. Zusammen mit dem zweiten Winkelschenkel 15 bilden diese beiden Auflagen 20 zwei U-förmige, federnde Klammern 21, die zur Aufnahme des Randes des betreffenden, an die jeweilige Seitenwand 2 bzw. 3 anstoßenden Deckbleches 11 bzw. 12 dienen. Eine Einführschräge 22 erleichtert das Einschieben des Deckbleches 11, 12 in die Klammern 21.

An die eine Stirnseite des Winkelträgers 13 ist ein Winkelteil 23 angeformt, welches zwei Schenkel 24, 25 aufweist, die wiederum einen Winkel von neunzig Winkelgraden untereinander einschließen, der Winkel kann auch etwas größer als neunzig Grad sein. Am einen Schenkel 24 steht eine nach innen gerichtete Konsole 26 hervor, die mit dem anderen Schenkel 25 eine federnde, U-förmige Aufnahme 27 zum Aufschieben auf den Rand des Deckbleches 11 bzw. 12 bildet.

Der eine Schenkel 24 weist an seiner Außenseite eine durch Prägung entstandene Kontaktkuppe 28 auf, die sich bei montiertem Deckblech 11, 12 an die Innenseite der betreffenden Seitenwand 2 bzw. 3 infolge der Winkelstellung der beiden Schenkel 24 und 25 des Winkelteiles 23 federnd andrückt.

Zwischen dem Winkel träger 13 und dem Winkelteil 23 ist eine eingeprägte Sollbruchstelle 29 vorgesehen.

Der eine Schenkel 24 des Winkelteiles 23 weist eine zum zweiten Schenkel 25 hin gerichtete Abbiegung 30 auf.

An das Winkelteil 23 ist ein weiteres, mit ihm übereinstimmendes Winkelteil 31 angeformt, an das sich ein weiterer Winkelträger 32 anschließt, der wiederum mit dem Winkelträger 13 identisch ist. Mehrere Winkel träger 13, 32 und mehrere Winkelteile 23 und 31 hängen, über Sollbruchstellen 29 miteinander verbunden, aneinander.

### Zusammenstellung der Bezugszeichen

- 1: Baugruppenträger
- 2: Seitenwand
- 3: Seitenwand
- 4: Modulschiene
- 5: Modulschiene
- 6: Befestigungsflansch
- 7: Schraublöcher
- 8: oberer Rand (von 2, 3)
- 9: unterer Rand (von 2, 3)
- 10: Lochreihen
- 11: Deckblech (an Oberseite)
- 12: Deckblech (an Unterseite)
- 13: Winkelträger
- 14: Winkelschenkel, erster
- 15: Winkelschenkel, zweiter
- 16: Winkel
- 17: Abkantung
- 18: Schraubenaufnahme
- 19: Befestigungsschraube
- 20: Auflagen
- 21: Klammer
- 22: Einführschräge
- 23: Winkelteil
- 24: Schenkel
- 25: Schenkel
- 26: Konsole
- 27: Aufnahme
- 28: Kontaktkuppe
- 29: Sollbruchstelle
- 30: Abbiegung
- 31: Winkel teil, weiteres
- 32: Winkelträger, weiterer

## Patentansprüche

1. Baugruppenträger zur Aufnahme von mit elektrischen und elektronischen Bauteilen bestückten Steckbaugruppen
- mit zwei parallelen Seitenwänden, die durch wenigstens vier Modulschienen miteinander verbunden sind,
- mit je einem Deckblech an seiner Oberseite und seiner Unterseite,
- mit Lochreihen für Befestigungsschrauben an den oberen und unteren Rändern der Seitenwände,
- mit wenigstens einem Befestigungselement, welches an der Lochreihe angebracht und an dem das Deckblech befestigt ist,
**gekennzeichnet** durch folgende Merkmale:
- das Befestigungselement ist ein Winkelträger (13) aus dünnem, federelastischem Stahlblech,
- der Winkelträger (13) besitzt zwei Winkelschenkel (14 und 15), die einen Winkel (16) einschließen, der mehr als neunzig Winkelgrade beträgt,
- der erste Winkelschenkel (14) des Winkelträgers (13) ist zwischen Seitenwand (2, 3) und Deckblech (11, 12) eingesetzt,
- der erste Winkelschenkel (14) trägt eine Schraubenaufnahme (18) für eine Befestigungsschraube (19),
- die Befestigungsschraube (19) ist durch ein Loch der Lochreihe (10) hindurchgeführt und in die Schraubenaufnahme (18) eingedreht,
- der zweite Winkelschenkel (15) weist wenigstens eine durch Ausstanzung dieses Winkelschenkels (15) hergestellte Auflage (20) für das Deckblech (11, 12) auf,
- dieser zweite Winkelschenkel (15) bildet zusammen mit der Auflage (20) eine U-förmige, federnde Klammer (21),
- die Klammer (21) dient zur Aufnahme des Randes des an die Seitenwand (2, 3) anstoßenden Deckbleches (11, 12).

2. Baugruppenträger nach Anspruch 1, dadurch **gekennzeichnet,** daß als Schraubenaufnahme (18) ein aus einer Stanzung und Prägung hergestelltes Loch dient.

3. Baugruppenträger nach einem der Ansprüche 1 oder 2, dadurch **gekennzeichnet,** daß der erste Winkelschenkel (14) eine Abkantung (17) aufweist, die zum zweiten Winkelschenkel (15) gerichtet ist.

4. Baugruppenträger nach einem der Ansprüche 1 bis 3, **gekennzeichnet** durch ein an der Stirnseite des Winkelträgers (13) angeformtes Winkelteil (23) mit zwei Schenkeln (24 und 25), deren einer (24) eine nach innen gerichtete Konsole (26) für das Deckblech (11, 12) aufweist und der andere Schenkel (25) mit der Konsole (26) eine federnde, U-förmige Aufnahme (27) für das Deckblech (11, 12) bildet.

5. Baugruppenträger nach Anspruch 4, dadurch **gekennzeichnet,** daß der eine Schenkel (24) des Winkelteiles (23) an seiner Außenseite eine Kontaktkuppe (28) aufweist.

6. Baugruppenträger nach Anspruch 4 oder 5, dadurch **gekennzeichnet,** daß der eine Schenkel (24) des Winkelteiles (23) eine zum zweiten Schenkel (25) gerichtete Abbiegung (30) aufweist.

7. Baugruppenträger nach einem der Ansprüche 4 bis 6, dadurch **gekennzeichnet,** daß zwischen dem Winkelträger (13) und dem Winkelteil (23) eine Sollbruchstelle (29) vorgesehen ist.

8. Baugruppenträger nach einem der Ansprüche 4 bis 7, dadurch **gekennzeichnet,** daß mehrere Winkelträger (13 und 31) mit mehreren Winkelteilen (23 und 30) zusammenhängen und ein Band bilden.

## Claims

1. Sub-rack for accommodating plug-in units equipped with electrical and electronic components
- with two parallel side walls, which are connected together by at least four module rails,
- with a respective cover plate at its upper side and underside,
- with rows of holes for fastening screws at the upper and lower edges of the side walls,
- with at least one fastening element, which is attached to the row of holes and to which the cover plate is fastened,
characterised by the following features:
- the fastening element is an angle support (13) of thin, resilient steel sheet,
- the angle support (13) has two angle legs (14 and 15), which form an angle (16) of more than ninety angular degrees,
- the first angle leg (14) of the angle support (13) is inserted between the side wall (2, 3) and the cover plate (11, 12),
- the first angle leg (14) bears a screw receptacle (18) for a fastening screw (19),
- the fastening screw (19) is passed through a hole of the row of holes (10) and screwed into the screw receptacle (18),
- the second angle leg (15) comprises at least one seat (20), produced by punching out this angle leg (15), for the cover plate (11, 12),
- this second angle leg (15) forms with the seat (20) a U-shaped resilient clamp (21),
- the clamp (21) serves to accommodate the edge of the cover plate (11, 12) adjoining the side wall (2, 3).

2. Sub-rack according to claim 1, characterised in that a hole produced by punching and stamping serves as the screw receptacle (18).

3. Sub-rack according to claim 1 or 2, characterised in that the first angle leg (14) comprises a bent portion (17), which is directed towards the second angle leg (15).

4. Sub-rack according to any one of claims 1 to 3, characterised by an angle part (23), which is moulded onto the front end of the angle support (13), with two legs (24 and 25), one (24) of which comprises an inward directed bracket (26) for the cover plate (11, 12) and the other leg (25) forms with the bracket (26) a resilient, U-shaped receptacle (27) for the cover plate (11, 12).

5. Sub-rack according to claim 4, characterised in that one leg (24) of the angle part (23) comprises a contact pip (28) on its outside.

6. Sub-rack according to claim 4 or 5, characterised in that one leg (24) of the angle part (23) comprises a bend (30) directed towards the second leg (25).

7. Sub-rack according to any one of claims 4 to 6, characterised in that a predetermined breaking point (29) is provided between the angle support (13) and the angle part (23).

8. Sub-rack according to any one of claims 4 to 7, characterised in that a plurality of angle supports (13 and 31) are joined to a plurality of angle parts (23 and 30) and form a strip.

## Revendications

1. Support de modules destiné à recevoir des modules enfichables équipés de composants électriques et électroniques, ayant
- deux parois latérales parallèles reliées par au moins quatre barres modulaires,
- une plaque de couverture sur le dessus et une plaque de couverture sur le dessous,
- des rangées de trous pour des vis de fixation sur le bord supérieur et le bord inférieur des parois latérales,
- au moins un élément de fixation qui est monté sur la rangée de trous et auquel est fixée la plaque de couverture,
caractérisé par les caractéristiques suivantes :
- l'élément de fixation est un support en équerre (13) en tôle d'acier élastique mince,
- ce support en équerre (13) a deux ailes (14 et 15) qui font entre elles un angle (16) supérieur à 90°,
- la première aile (14) du support en équerre (13) est engagée entre la paroi latérale (2, 3) et la plaque de couverture (11, 12),
- la première aile (14) porte un récepteur de vis (18) pour une vis de fixation (19),
- la vis de fixation (19) passe par un trou de la rangée de trous (10) et est vissée dans le récepteur de vis (18),
- la deuxième aile (15) présente pour la plaque de couverture (11, 12) au moins un appui (20) réalisé par découpage de cette aile (15),
- cette deuxième aile (15) forme avec l'appui (20) une pince élastique en forme de U (21),
- la pince (21) est destinée à recevoir le bord de la plaque de couverture (11, 12) adjacente à la paroi latérale (2, 3).

2. Support de modules selon la revendication 1, caractérisé par le fait que le récepteur de vis (18) est un trou réalisé par découpage et estampage.

3. Support de modules selon l'une des revendications 1 et 2, caractérisé par le fait que la première aile (14) présente un bord plié (17) qui est dirigé vers la deuxième aile (15).

4. Support de modules selon l'une des revendications 1 à 3, caractérisé par un élément en équerre (23) fait sur le côté frontal du support en équerre (13) et ayant deux ailes (24 et 25) dont l'une (24) présente une console dirigée vers l'intérieur (26) pour la plaque de couverture (11, 12) et l'autre (25) forme avec la console (26) un récepteur élastique en forme de U (27) pour la plaque de couverture (11, 12).

5. Support de modules selon la revendication 4, caractérisé par le fait qu'une aile (24) de l'élément en équerre (23) présente sur sa face extérieure un mamelon de contact (28).

6. Support de modules selon l'une des revendications 4 et 5, caractérisé par le fait qu'une aile (24) de l'élément en équerre (23) présente un bord infléchi (30) dirigé vers la deuxième aile (25).

7. Support de modules selon l'une des revendications 4 à 6, caractérisé par le fait qu'entre le support en équerre (13) et l'élément en équerre (23) est prévu un endroit de rupture (29).

8. Support de modules selon l'une des revendications 4 à 7, caractérisé par le fait que plusieurs supports en équerre (13 et 31) sont attachés à plusieurs éléments en équerre (23 et 30) et forment une bande.
